# EUROPÄISCHE PATENTSCHRIFT

(11) **EP 4 481 411 B1**
(45) Veröffentlichungstag und Bekanntmachung des Hinweises auf die Patenterteilung: **18.11.2026**
(21) Anmeldenummer: 24183030.6
(22) Anmeldetag: 19.06.2024
(51) Int. Cl.: G01R 31/327, H03K 17/18

(54) **VORRICHTUNG UND VERFAHREN ZUM ÜBERWACHEN EINER ABSCHALTFÄHIGKEIT**
DEVICE AND METHOD FOR MONITORING A SHUT-DOWN CAPABILITY
DISPOSITIF ET PROCÉDÉ DE SURVEILLANCE D'UNE CAPACITÉ DE COUPURE

(30) Priorität: 22.06.2023 DE 102023116488
(43) Veröffentlichungstag der Anmeldung: 25.12.2024
(73) Patentinhaber: Turck Holding GmbH, 58553 Halver (DE)
(72) Erfinder: vom Stein, Johannes, 42499 Hückeswagen (DE)
(74) Vertreter: DTS Patent- und Rechtsanwälte PartmbB

(56) Entgegenhaltungen:
- DE-A1- 102022 118 881
- US-A1- 2012 161 817
- US-A1- 2019 056 448

## Beschreibung

Die vorliegende Offenbarung betrifft eine Vorrichtung zum Überwachen einer Abschaltfähigkeit eines Verbrauchers, insbesondere durch ein Schaltelement. Ferner betrifft die Offenbarung Verfahren zum Überwachen einer Abschaltfähigkeit, sowie eine Steuervorrichtung, ein System und ein Computerprogramm.

Eine typische Herausforderung bei derartigen Vorrichtungen kann darin bestehen, die Abschaltfähigkeit eines digitalen Ausgangs im zugeschalteten Zustand diagnostizieren zu können. Insbesondere dann, wenn eine Last angekoppelt ist.

Im Bereich der funktionalen Sicherheit, beispielsweise entsprechend der SIL-Norm IEC 61508 und dem Performance Level nach IEC 13849, sollte zum Schutz vor Verletzungen bei Dritten, irreversiblen Schäden und Unfällen mit Todesfolge eine Sicherheitsfunktion mit sehr hoher Wahrscheinlichkeit gemäß ihrer Spezifikation vorgesehen sein. Es sollte gewährleistet werden können, das sichere digitale Ausgänge mit hoher Wahrscheinlichkeit abschaltfähig sind.

Aus dem Stand der Technik sind Methoden und Verfahren bekannt, um eine Fähigkeit zum Abschalten zu diagnostizieren. Es kann eine zyklische Durchführung einer Abschaltung, beispielsweise in einem Zeitbereich von 1 ms bis alle 500 ms vorgesehen sein. Die zyklische Abschaltung kann für die Funktion der Schaltelemente in praktischen Anwendungen störend sein. Dahingehend kann es notwendig sein, die Abschaltfähigkeit zu diagnostizieren und mit hoher Wahrscheinlichkeit sicherzustellen, ohne dass eine Abschaltung durchgeführt werden muss.

Im Stand der Technik werden verschiedene Verfahren vorgeschlagen. In der DE 10 2020 113 822 A1 ist ein sicherer Ausgang gezeigt, bei dem die Ausgangsschaltelemente nicht zur Testung zyklisch abgeschaltet werden müssen, da diese sich in einem Regelkreis befinden, durch den ihre Funktionsfähigkeit überwacht werden kann. Ein wesentlicher Nachteil dieser Lösung ist, dass das Ausgangsschaltelement nicht voll durchgesteuert werden kann, wenn es sich in einem Regelkreis befindet und eine höhere Spannung an der Halbleiterstrecke abfällt, als in einem voll durchgesteuerten Zustand abfallen würde. Dadurch kann eine unnötige Erwärmung des Schaltelementes eintreten. Darüber hinaus ist der Regelkreis aufwändig ausgebildet und bedarf einer hohen Anzahl an Bauteile, was wiederrum zu einer größeren Platine und weiteren Kosten führen kann.

In der US 007 702 302 B1 ist eine Verschaltung gezeigt, die in der Versorgung einen FET und einen Messwiderstand zur Strommessung aufweist. Nachteilig in der US 007 702 302 B1 ist, dass ein zyklischer Test des FETs im eingeschalteten Zustand nicht stattfinden kann und deshalb kein hoher Sicherheitslevel erreicht werden kann. Darüber hinaus sind die Messwiderstände im Leistungspfad geschaltet, woraus Leistungsverluste resultieren können.

Die US 2012/0161817 A1 beschreibt eine Schaltung, um eine Spule eines Relais mit elektrischer Leistung zu versorgen. Der hierzu erforderliche Strom kann von einer Batterie bereitgestellt werden. Es sind zwei parallel zueinander verlaufende Zuleitungen vorgesehen, in denen jeweils als Schalter ein Feldeffekttransistor vorgesehen ist. Zur Bestromung der Spule werden die Gate-Spannungen der Feldeffekttransistoren synchron auf einen Wert gebracht, bei dem durch beide Feldeffekttransistoren Strom fließt. In regelmäßigen Intervallen wird die Gate-Spannung geringfügig abgesenkt und der Spannungsabfall zwischen Drain und Source gemessen. Die Messwerte werden auf einen Drahtbruch in der Zuleitung zum Feldeffekttransistor ausgewertet. Nachteilig kann sein, dass die Sperrschichtkapazität nicht gemessen wird, sondern der FET nur zyklisch mit einer geringeren Spannung angesteuert wird. Zusätzlich muss die Lastspannung gemessen werden. Es wird keine Messsystematik mit hoher Ausfallsicherheit aufgezeigt.

Die EP 133 5471 A2 und die DE 382 1065 zeigen eine Schutzbeschaltung durch einen "Monitor" Transistor. Der Haupttransistor wird abgeschaltet, wenn eine zu hohe Spannung an ihm abfällt. Nachteilig kann hierbei sein, dass der Haupttransistor nur geschützt wird, wenn eine zu hohe Spannung an ihm abfällt, aber nicht, wenn er fehlerhaft niederohmig geworden ist und deshalb nicht mehr abschaltfähig ist.

In den ausgeführten Fällen ist es nicht möglich, die Abschaltfähigkeit eines digitalen Ausgangs im zugeschalteten Zustand zu diagnostizieren. Vor dem Hintergrund dieses Standes der Technik besteht die Aufgabe der vorliegenden Offenbarung darin, eine Vorrichtung und ein Verfahren anzugeben, die jeweils geeignet sind, die zuvor genannten Nachteile des Stands der Technik zumindest teilweise zu überwinden und den Stand der Technik zu bereichern.

Weiterer relevanter Stand der Technik wird in folgenden Dokumenten offenbart: US 2019/056448 A1, DE 10 2022 118881 A1, US 2012/161817 A1.

Gelöst wird die Aufgabe durch die Merkmale des unabhängigen Patentanspruchs. Die nebengeordneten Patentansprüche und die Unteransprüche haben jeweils optionale Weiterbildungen der Offenbarung zum Inhalt.

Danach wird die Aufgabe gelöst durch eine Vorrichtung zum Überwachen einer Abschaltfähigkeit eines mit einem ersten Strompfad mit einer Stromversorgung verbundenen elektrischen Verbrauchers. Im ersten Strompfad ist ein erstes elektrisches Stellelement vorgesehen, dessen Stromdurchleitungsvermögen mittels eines ersten Stellsignals veränderbar ist. Der Betriebszustand des ersten Stellelements ist durch eine erste elektrische Größe, die ein erstes Kapazitätsvermögen am ersten Stellelement ist, und eine erste Spannung bedingt, die von einer Spannungsmesseinrichtung ermittelt wird, charakterisiert. Die Vorrichtung sieht in einem zweiten Strompfad mit einer weiteren Stromversorgung ein zweites Stellelement zum Bereitstellen des erstens Stellsignals vor, dessen Stromdurchleitungsvermögen mittels eines zweiten Stellsignals veränderbar ist. Der Betriebszustand des zweiten Stellelements ist durch eine zweite elektrische Größe, die ein zweites Kapazitätsvermögen am zweiten Stellelement ist, und eine zweite Spannung bedingt, charakterisiert. Das erste Kapazitätsvermögen und das zweite Kapazitätsvermögen sind in Reihe geschaltet. Weiterhin ist eine Steuervorrichtung vorgesehen, die ausgebildet ist, das zweite Stellelement mittels des zweiten Stellsignals zumindest in zeitlich voneinander beabstandeten Messintervallen anzusteuern und dabei gewonnene Werte der ersten elektrischen Größe auf ein Erkennen einer Fehlfunktion für das Abschalten des ersten Stellelementes auszuwerten, und wobei das Auswerten einen Vergleich der gewonnen Werte der ersten elektrischen Größe mit wenigstens einem Referenzvorgabewert beinhaltet.

Im Sinne der vorliegenden Offenbarung kann unter Kapazitätsvermögen eine elektrische Größe verstanden werden, mit der Fähigkeit eine elektrische Ladung zu speichern und eine Kapazität aufzubauen. Ein Kapazitätsvermögen kann durch Anlegen einer Spannung aufgebaut werden.

Im Sinne der vorliegenden Offenbarung kann unter der Abschaltfähigkeit die Fähigkeit eines Stellelementes, beispielsweise eines Feldeffekttransistors (FET) verstanden werden, bei dem ein Stromfluss zwischen Source und Drain vollständig unterbrochen werden kann, wenn eine geeignete Steuerspannung an das Gate angelegt ist. Die Abschaltfähigkeit kann auftreten, wenn die Spannung am Gate so eingestellt wird, dass das elektrische Feld im Kanal stark genug ist, um den Stromfluss vollständig zu blockieren. In diesem Zustand wird der FET als "ausgeschaltet" betrachtet und es fließt nur ein sehr kleiner Leckstrom zwischen Source und Drain. Das Verhältnis zwischen dem Leckstrom im ausgeschalteten Zustand und dem maximalen Strom im eingeschalteten Zustand kann als Abschaltverhältnis oder Abschaltstromverhältnis bezeichnet werden.

Im Sinne der vorliegenden Offenbarung kann ein elektrischer Verbraucher Geräte oder Komponenten in einem elektrischen System darstellen, welche elektrische Energie aufnehmen und in eine andere Form von Energie umwandeln oder nutzen.

Im Sinne der vorliegenden Offenbarung kann sich das Stromdurchleitungsvermögen bei einem Feldeffekttransistor auf die Fähigkeit des Transistors beziehen, einen elektrischen Strom zwischen dem Source- und dem Drain-Terminal zu leiten, wenn eine geeignete Steuerspannung am Gate angelegt ist.

Die zuvor beschriebene Vorrichtung bietet dabei eine Reihe von Vorteilen. Unter anderem kann mittels der offenbarten Vorrichtung festgestellt werden, wenn die Spannung der Sperrschichtkapazität unter einer vordefinierten Schwelle liegt, so dass das Stellelement (Feldeffekttransistor) nicht weiter abschaltfähig ist und somit nicht mehr gewährleistet werden kann, dass der digitale Ausgang und/oder eine elektrische Last spannungsfrei geschaltet sind. Somit können weitere Maßnahmen zum Schutz ergriffen werden. Es kann vorgesehen sein, dass über eine zweite Abschaltung aktiviert wird und der digitale Ausgang und/oder eine elektrische Last spannungsfrei geschaltet werden. Zudem kann bei einem Schaltelement festgestellt werden, dass die Abschaltung nicht mehr gewährleistet ist und eine Fehlermeldung ausgegeben werden, um eine erneute Zuschaltung zu vermeiden/unterbinden.

Nachfolgend werden mögliche Weiterbildungen des oben beschriebenen Verfahrens im Detail erläutert.

Es kann vorgesehen sein, dass eine Kapazität in der Vorrichtung vorgesehen ist. Die Kapazität kann parallel zum zweiten Stellelement, zum Vergrößern des Kapazitätsvermögen des zweiten Stellelements, gekoppelt sein. Eine Kapazität, insbesondere die Sperrschichtkapazität kann durch einen kapazitiven Spannungsteiler gemessen/ermittelt werden. Dazu wird die weitere Kapazität in Reihe mit der zu messenden Kapazität von dem ersten Stellelement (Kapazität G-S-Strecke) geschaltet. Das zweite Stellelement kann die Kapazität zuschalten. Im geschalteten Zustand des zweiten Stellelements ist die Kapazität überbrückt. Im nicht geschalteten Zustand (gesperrter Zustand) ist die Kapazität geschaltet und eine Spannung fällt ab. Alternativ kann vorgesehen sein, dass das zweite Stellelement eine Drain-Source-Kapazität aufweist, die derart dimensioniert ist, dass diese die Aufgabe der Kapazität erfüllt. Ist die Drain-Source-Kapazität zu gering dimensioniert und/oder ist eine größere Bauart des zweiten Stellelements notwendig, um eine entsprechende Kapazität zu erzielen, kann eine weitere Kapazität parallel zum zweiten Stellelement geschaltet werden, welche eine entsprechend größere Kapazität aufweisen kann.

Es kann vorgesehen sein, dass das zweite Kapazitätsvermögen oder das zweite Kapazitätsvermögen in Parallelschaltung mit der Kapazität und das erste Kapazitätsverhalten eine gleiche Kapazitätsgrößenordnung aufweisen, und wobei die Kapazitätsgrößenordnung in einem Bereich von wenigstens 100 pF bis höchstens 10 nF liegt. Somit kann der entsprechende Spannungsteiler und ein entsprechender Spannungsabfall erzielt werden, um das erste Stellelement noch zu schalten, aber gleichzeitig eine Gate-Source-Spannung zu ermitteln.

Es kann vorgesehen sein, dass das erste Stellelement und das zweite Stellelement ein Transistor ist und das Stellsignal ein Steuerstrom oder eine Steuerspannung ist, wobei vorgesehen ist, dass der Transistor ein n-Kanal oder ein p-Kanal Feldeffekttransistor ist.

Es kann vorgesehen sein, dass die Spannungsmesseinrichtung als ein Operationsverstärker ausgebildet ist. Über den Operationsverstärker kann der ermittelte Wert für die Gate-Source-Spannung mit einem Referenzwert verglichen werden. Die Differenz kann entsprechend ausgewertet werden und im Ergebnis auf das Abschaltverhalten oder einen Fehler im Abschaltverhalten zurückgeführt werden. Die Differenz kann weiter an die Steuervorrichtung übertragen und durch diese verarbeitet werden.

Es kann vorgesehen sein, dass die Spannungsmesseinrichtung als ein Analog-Digital-Wandler ausgebildet ist und in Abhängigkeit von dem Wert für die erste elektrische Größe ein digitales Signal an die Steuervorrichtung bereitstellt. Über den Analog-Digital-Wandler kann der als analoges Spannungssignal gewonnene Wert für die erste elektrische Größe in ein digitales Signal gewandelt werden. Das gewandelte digitale Signal kann der Steuervorrichtung zur weiteren Verarbeitung übertragen werden.

Es kann vorgesehen sein, dass die Steuervorrichtung den Wert für die erste elektrische Größe mit wenigstens einem ersten und/oder zweiten Referenzvorgabewert vergleicht, und wobei der/die Referenzvorgabewert(e) über einen Widerstandsspannungsteiler bereitgestellt werden. Die Referenzvorgabewerte können über Widerstände so eingestellt werden, dass diese die Grenzen eines Spannungswerts darstellen, bei welchem das erste Stellelement technisch noch in der Lage ist abgeschaltet zu werden. Sollte das erste Stellelement nicht mehr abschaltbar sein, da es beispielsweise durchlegiert ist, so liegt der gewonnene Werte für die erste elektrische Größe außerhalb des durch den Widerstandsspannungsteilers bereitgestellten Wertebereichs.

Es kann vorgesehen sein, dass zum Erkennen, dass keine Fehlfunktion für das Abschalten des ersten Stellelements vorliegt, die erste elektrische Größe ausgehend von einem Maximalwert um einen Faktor vermindert ist, sodass das erste Stellelement noch nicht abgeschaltet wird oder, wenn es abgeschaltet ist, abgeschaltet verbleibt, und dass durch den Verbraucher ein zum Ausführen dessen Funktion ausreichender Strom fließt. Es kann festgestellt werden, dass die Sperrschichtkapazität regulär vorhanden ist, wenn eine verminderte Spannung anliegt, die zum Durchschalten des ersten Stellelements ausreichend ist. Somit wird das erste Stellelement noch als abschaltfähig beurteilt. Das Verfahren zur Überwachung der Abschaltfähigkeit wird nach dem Absenden eines Messimpulses beendet und der Ausgangszustand der Vorrichtung tritt wieder ein und die Schaltung arbeitet im Normalbetrieb, beispielsweise zur Schaltung des elektrischen Verbrauchers.

Es kann vorgesehen sein, dass in dem ersten Strompfad ein drittes Stellelement vorgesehen ist, und das dritte Stellelement in Reihe zu dem ersten Schaltelement geschaltet ist. Sollte die Sperrschichtkapazität durch eine Durchlegierung sinken und somit auch die abfallende Spannung unter einen Referenzvorgabewert, wird geschlussfolgert, dass das erste Stellelement nicht mehr abschaltfähig ist und die entsprechenden Aufgaben in der Vorrichtung nicht mehr der Norm entsprechend erfüllt werden, womit über einer alternativen Abschaltweg der digitale Ausgang beziehungsweise die elektrische Last abgeschaltet werden kann. Diese alternative Abschaltweg wird über das dritte Stellelement bereitgestellt. Ferner kann eine Fehlermeldung über die Steuervorrichtung durch eine Signallampe, Anzeige auf einem Display, übertrage Nachricht an ein weiteres Gerät, zur Warnung eines Bedieners/Anwenders, bereitgestellt werden.

Es kann vorgesehen sein, dass zum Erkennen einer Fehlfunktion für das Abschalten des ersten Stellelements, die erste elektrische Größe ausgehend von einem Maximalwert um einen Faktor soweit vermindert ist, dass das erste Stellelement nicht mehr abgeschaltet wird und der zum Ausführen der Funktion des Verbrauchers ausreichende Strom mittels des dritten Stellelements unterbunden wird. Somit kann die Vorrichtung in einen sicheren Zustand geschaltet werden und der digitale Ausgang beziehungsweise die elektrische Last spannungsfrei geschaltet werden, so dass Dritte nicht zu Schaden kommen.

Es kann vorgesehen sein, dass die Vorrichtung ferner ein Widerstandselement aufweist, und wobei das Widerstandselement parallel zum ersten Kapazitätsvermögen des ersten Stellelements geschaltet ist. Die Vorrichtung ist derart gestaltet, dass der digitale Ausgang abgeschaltet wird, wenn kein zweites Steuersignal an dem zweiten Stellelement anliegt. Es wird also nur für die Dauer eines kurzen Testpulses die Durchschaltenergie bereitgestellt. Dazu kann das Widerstandselement vorgesehen sein, welches so dimensioniert werden kann, dass ein beliebiger Fehler an dem zweiten Stellelement nicht dazu führen kann, dass das erste Stellelement nicht innerhalb einer vorgegebenen Prozesssicherheitszeit abschaltet.

Das oben Beschriebene lässt sich mit anderen Worten und auf eine mögliche konkretere Ausgestaltung der Offenbarung wie nachfolgend beschrieben zusammenfassen, wobei die nachfolgende Beschreibung als für die Offenbarung nicht einschränkend auszulegen ist.

Die Abschaltfähigkeit eines digitalen Ausgangs soll im zugeschalteten Zustand durch Messung der Sperrschichtkapazität des abschaltenden Feldeffekttransistors diagnostiziert werden.

Ein Feldeffekttransistor kann derart aufgebaut sein, dass ein Substrat dotiert wird und dadurch N-Bereiche und P-Bereiche erhält. Beispielsweise kann ein selbstsperrender N-Kanal-FET (Feldeffekt-Transistor) an den N-Bereichen mit D (Drain) und S (Source) kontaktiert werden. Im P-Bereich kann er eine Isolationsschicht aufweisen, so dass der G (Gate) Anschluss nichtleitend verbunden ist. In diesem Bereich befindet sich die Sperrschicht. Bei einem Anlegen einer Spannung an G zu S kommt es zu einer kapazitiven Ladung, durch die die Sperrschicht zwischen D und S leitend wird.

Aus diesem Aufbau ergibt sich, dass ein FET eine Sperrschichtkapazität aufweist, die zwischen G und S messbar ist. Auch im zugeschalteten Zustand, bei dem die Sperrschicht mit Spannung geladen ist, kann die Kapazität gemessen werden.

Ein FET kann zwei wesentliche Fehlerzustände zwischen D und S aufweisen: Zum einen kann er dauerhaft hochohmig werden. Dann kann er durch Anlegen der Spannung an G nach S nicht durchgesteuert werden. Wenn der abgeschaltete Zustand der sichere Zustand ist, dann ist der FET in die sichere Richtung ausgefallen. Zum anderen kann der FET auch dauerhaft niederohmig werden. Dabei wird der Sperrbereich "durchlegiert". Der FET ist dann nicht mehr abschaltfähig. Im durchlegierten Zustand weist der FET nicht mehr dieselbe Sperrschichtkapazität auf. Sie verringert sich, da der Teil des Sperrbereiches, der leitend ist, das Potential des S-Pols der Sperrschichtkapazität aufweist. Die Kapazität zwischen G und S ist damit wesentlich verringert. Das Dielektrikum muss einen Bereich aufweisen, in dem Ladungsträger angereichert werden und somit auch einen Bereich, in dem Ladungsträger verarmt werden. Die Durchlegierung geschieht in der direktesten Verbindung zwischen den dotierten Bereichen, was dem Anreicherungsbereich entspricht. Daher ist davon auszugehen, dass die verbleibende Sperrschichtkapazität weniger als 50% der vorherigen ist.

Eine Kapazität kann durch einen kapazitiven Spannungsteiler gemessen werden. Dazu wird eine weitere Kapazität in Reihe mit der zu messenden Kapazität geschaltet. Ein weiterer FET kann diese Kapazität zuschalten. Der FET selbst weist eine Drain-Source-Kapazität auf, die so dimensioniert sein kann, dass diese bereits für sich genommen zu diesem Zweck ausreicht. Alternativ kann eine zusätzliche Kapazität zugeschaltet werden.

Die Sperrschichtkapazität und die Reihenkapazität können so dimensioniert sein, dass sie in derselben Größenordnung liegen, zum Beispiel im Bereich zwischen 100 pF bis 10 nF. Wenn der weitere FET hochohmig geschaltet wird, teilt sich die Ladungsmenge der Sperrschichtkapazität auf den kapazitiven Teiler auf. Die geteilte Spannung sollte so dimensioniert sein, dass die Sperrschichtkapazität ausreichend geladen ist, um den FET weiter durchzusteuern. Die geteilte Spannung kann auf einen Bereich abgefragt werden, innerhalb der sie liegen muss.

Wenn der FET durchlegiert ist, dann liegt die Spannung außerhalb des gültigen Bereiches. Damit kann diagnostiziert werden, dass der FET nicht mehr abschaltfähig ist. Zur Messung der Spannungen an einem kapazitiven Spannungsteiler können Operationsverstärker vorgesehen sein, die die durch einen Widerstandsspannungsteiler bereitgestellten Spannungen mit einer Referenzspannung vergleichen.

Alternativ kann die Spannung mit anderen Messmethoden erfasst werden, zum Beispiel mit einem Analog-Digital-Wandler von einem Microcontroller.

Die Applikation verfügt insbesondere über einen weiteren Abschaltweg, zum Beispiel einen weiteren FET, der in Reihe mit dem oben beschriebenen FET geschaltet ist. Wenn also bei der Testung festgestellt wird, dass der FET nicht mehr abschaltfähig, also durchlegiert, ist, dann wird eine Abschaltung über den redundanten Abschaltweg ausgelöst.

Die Applikation verfügt über eine Ansteuerung, zum Beispiel einen Gate-Treiber oder einen digitalen Ausgang eines Mikrokontrollers an D von dem weiteren FET. Die Diagnoseverschaltung ist so gestaltet, dass der Ausgang abgeschaltet wird, wenn an D vom weiteren FET keine Spannung anliegt. Es wird also nur für die Dauer eines kurzen Testpulses die Durchschaltenergie bereitgestellt.

Dazu kann ein Widerstand vorgesehen sein, der so dimensioniert wird, dass ein beliebiger Fehler vom weiteren FET nicht dazu führen kann, dass der FET nicht innerhalb einer vorgegebenen Prozesssicherheitszeit abschaltet. Die Verschaltung ist so gestaltet, dass kein Einfachfehler zum Verlust der Sicherheitsfunktion führen kann und eine sehr hohe Diagnosedeckung vorliegt. Während des Tests ist der FET kurzzeitig nicht voll durchgesteuert. Das führt zu einem erhöhten Spannungsabfall (D-S-Strecke) und damit zur Erwärmung. Eine vorteilhafte Auslegung von dem FET kann in einer Überdimensionierung bestehen, sodass eine höhere Leistung ausgehalten wird, als für den bemessenen Strom bei dauerhaft voller Durchschaltung nötig wäre.

Mit folgendem Verfahren kann der Ausgangs-FET auf seine Schaltfähigkeit überprüft werden.

Ein Ausgangszustand beinhaltet, dass der weitere FET D mit Spannung beaufschlagt ist, G mit einer Spannung beaufschlagt ist, der weitere FET durchgeschaltet ist (D-S-Strecke), der FET G mit Spannung beaufschlagt ist, FET D mit Spannung versorgt ist, der FET durchgeschaltet (D-S-Strecke) ist.

Es wird ein Testimpuls an den weiteren FET G angelegt, wodurch die G-S Spannung auf null geht und der weitere FET hochohmig wird. Der Messkondensator und die Sperrkapazität von dem weiteren FET bilden einen kapazitiven Spannungsteiler mit der geladenen Sperrschichtkapazität von dem FET. Dadurch wird der FET entsprechend des kapazitiven Verhältnisses entladen und die resultierende Spannung verbleibt an dem FET G.

Die Spannung an dem FET G kann gemessen werden, wenn die Sperrschichtkapazität regulär vorhanden ist. Dann liegt eine verminderte Spannung an, die aber zum Durchschalten von dem FET weiter ausreicht. Wenn die Sperrschichtkapazität aufgrund einer Durchlegierung deutlich verringert ist, liegt eine deutlich verringerte Spannung an.

Die Auswertung, ob die Spannung unter einer definierten Schwelle liegt, kann unter den folgenden Kriterien erfolgen. Wenn die Spannung nur etwas vermindert ist, ist der FET weiter abschaltfähig.

Der Testimpuls endet, wodurch der Ausgangszustand wieder eintritt.

Wenn die Spannung unterhalb der definierten Schwelle vermindert ist, ist der FET nicht weiter abschaltfähig. Der Ausgang wird über einen zweiten Abschaltweg abgeschaltet. Eine Fehlermeldung wird ausgegeben und eine erneute Zuschaltung unterbunden. Wenn die Gate-Spannung U_G von dem FET mit und ohne Testimpuls erfasst wird, können folgende Fehler festgestellt werden:
(1) Eine Durchlegierung von dem FET (D-S-Strecke niederohmig) führt zur Verringerung der Kapazität C_GS und damit zur Erhöhung der Spannung U_G während des Testpulses.
(2) Eine Durchlegierung von dem FET (D-G-Strecke oder S-G-Strecke niederohmig) führt zu einem Gate-Schluss und damit zur Verringerung (oder Erhöhung) der Spannung. Eine Durchlegierung oder Hochohmigkeit des weiteren FETs (D-S-Strecke) führt zu einer Veränderung des kapazitiven Spannungsteilers und damit zu einer Verringerung oder Erhöhung der Spannung.

Wird ein fehlerhafter Zustand festgestellt, erfolgt eine Abschaltung.

Alternativ kann in einer zweiten Variante vorgesehen sein, dass die aus der kapazitiven Entladung resultierende Änderung der Drain-Source Spannung gemessen wird. Das kann 1. über eine Verschaltung erfolgen, die nur den Wechselspannungsanteil misst, oder 2. durch einen Bandpass-Filter, wenn in einer bestimmten Frequenz zyklisch ab- und zugeschaltet wird Die Spannungen könnten auch mit einem Analog-Digital-Wandler erfasst und gemessen werden.

Zudem wird ein Verfahren zum Überwachen einer Abschaltfähigkeit eines mit einem ersten Strompfad mit einer Stromversorgung verbundenen elektrischen Verbrauchers bereitgestellt, wobei im ersten Strompfad ein erstes elektrisches Stellelement vorgesehen ist, dessen Stromdurchleitungsvermögen mittels eines ersten Stellsignals veränderbar ist, wobei der Betriebszustand des ersten Stellelements durch eine erste elektrische Größe, die ein erstes Kapazitätsvermögen am ersten Stellelement ist, und eine erste Spannung bedingt, die von einer Spannungsmesseinrichtung ermittelt wird, charakterisiert ist, wobei die Vorrichtung in einem zweiten Strompfad mit einer weiteren Stromversorgung ein zweites Stellelement zum Bereitstellen des erstens Stellsignals vorsieht, dessen Stromdurchleitungsvermögen mittels eines zweiten Stellsignals veränderbar ist, wobei der Betriebszustand des zweiten Stellelements durch eine zweite elektrische Größe, die ein zweites Kapazitätsvermögen am zweiten Stellelement ist, und eine zweite Spannung bedingt, charakterisiert ist, wobei das erste Kapazitätsvermögen und das zweite Kapazitätsvermögen in Reihe geschaltet sind, und wobei eine Steuervorrichtung das zweite Stellelement mittels des zweiten Stellsignals zumindest in zeitlich voneinander beabstandeten Messintervallen ansteuert und dabei gewonnene Werte der ersten elektrischen Größe auf ein Erkennen einer Fehlfunktion für das Abschalten des ersten Stellelementes auswertet, und wobei das Auswerten einen Vergleich der gewonnen Werte mit einem Referenzvorgabewert beinhaltet.

Ferner wird eine Steuervorrichtung zum Ansteuern einer offenbarungsgemäßen Vorrichtung, die ausgebildet ist, das offenbarungsgemäße Verfahren auszuführen, bereitgestellt, mit einer Prozessoreinheit, die ausgebildet ist, Steuersignale bereitzustellen, um ein zweites Stellelement zumindest in zeitlich voneinander beabstandeten Messintervallen anzusteuern; einer Schnittstelle, die ausgebildet ist, Steuersignale bereitzustellen und gewonnene Werte einer ersten elektrischen Größe eines ersten Stellelements zu empfangen; und wobei die Prozessoreinheit weiter ausgebildet ist, Steuersignale bereitzustellen, um ein Erkennen einer Fehlfunktion für das Abschalten des ersten Stellelementes auszuwerten, und wobei das Auswerten einen Vergleich der gewonnen Werte der ersten elektrischen Größe mit wenigstens einem Referenzvorgabewert beinhaltet.

Ferner wird ein System mit einer ersten und einer zweiten offenbarungsgemäßen Vorrichtung bereitgestellt, wobei die erste und die zweite Vorrichtung somit insbesondere dupliziert vorliegen und derart angeordnet sind, dass der Minuspol der ersten (oberen) Vorrichtung (100) mit dem Pluspol der (unteren) Vorrichtung 100 gekoppelt ist.

Ferner betrifft die Offenbarung ein Computerprogramm. Die vorstehend beschriebenen Ausgestaltungen des Verfahrens können auch als ein Computerprogramm ausgebildet sein, wobei eine Steuervorrichtung (beispielsweise ein Computer, Mikrocontroller, DSP, FPGA und/oder SPS) zur Durchführung des offenbarungsgemäßen Verfahrens veranlasst wird, wenn das Computerprogramm auf einer Steuervorrichtung beziehungsweise auf einem Prozessor der Steuervorrichtung ausgeführt wird. Das Computerprogramm kann als Signal per Download bereitgestellt oder in einer Speichereinheit der Steuervorrichtung mit darin enthaltenem computer-lesbarem Programmcode gespeichert werden, um eine Steuervorrichtung zur Ausführung von Anweisungen gemäß dem oben genannten Verfahren zu veranlassen. Dabei kann das Computerprogramm auch auf einem maschinenlesbaren Speichermedium gespeichert sein.

Eine alternative Aufgabenlösung sieht daher ein Speichermedium, insbesondere ein computerlesbares Speichermedium vor, das zur Speicherung des offenbarungsgemäßen Verfahrens (als Programmcode) bestimmt ist und von einem Computer oder einem Prozessor des Computers lesbar ist. Der Programmcode veranlasst bei der Ausführung durch eine Prozessorschaltung eines Computers oder eines Computerverbunds, eine Ausführungsform des offenbarungsgemäßen Verfahrens auszuführen.

Das Speichermedium kann zum Beispiel zumindest teilweise als ein nichtflüchtiger Datenspeicher (zum Beispiel als eine Flash-Speicher und/oder als SSD - solid state drive) und/oder zumindest teilweise als ein flüchtiger Datenspeicher (zum Beispiel als ein RAM - random access memory) bereitgestellt sein. Das Speichermedium kann in der Prozessorschaltung in deren Datenspeicher angeordnet sein. Das Speichermedium kann aber auch beispielsweise als sogenannter Appstore-Server im Internet betrieben sein. Durch den Computer oder Computerverbund kann eine Prozessorschaltung mit zumindest einem Mikroprozessor bereitgestellt sein. Der Programmcode kann als Binärcode oder Assembler und/oder als Quellcode einer Programmiersprache (zum Beispiel C) und/oder als Programmskript (zum Beispiel Python) bereitgestellt sein.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Offenbarung umfassen auch nicht explizit genannte Kombinationen von zuvor oder im Folgenden bezüglich der in den Weiterbildungen beschriebenen Merkmalen der Offenbarung. Insbesondere wird dabei der Fachmann auch Einzelaspekte als Verbesserung oder Ergänzungen zu der jeweiligen Grundform der vorliegenden Offenbarung hinzufügen. Insbesondere können Merkmale der Vorrichtungsansprüche durch entsprechende Funktionen umgesetzt und/oder ausgeführt werden, wonach diese das Verfahren ergänzen beziehungsweise erweitern. Ferner können Verfahrensschritte durch entsprechende Implementierungsmodule in der Vorrichtung umgesetzt werden. Somit gilt das oben mit Bezug zur Vorrichtung beschriebene analog auch für das Verfahren und entsprechend umgekehrt.

Weitere Einzelheiten und Vorteile der Offenbarung sollen nun anhand der in den Zeichnungen dargestellten Ausführungsbeispiele näher erläutert werden.

Es zeigen:
- Fig. 1: eine schematische Darstellung einer offenbarungsgemäßen Vorrichtung;
- Fig. 2: eine schematische Darstellung eines offenbarungsgemäßen Systems;
- Fig. 3: eine weitere schematische Darstellung einer offenbarungsgemäßen Vorrichtung;
- Fig. 4: ein Ablaufdiagramm eines offenbarungsgemäßen Verfahrens; und
- Fig. 5: eine schematische Darstellung einer offenbarungsgemäßen Steuervorrichtung.

Die beiliegenden Zeichnungen sollen ein weiteres Verständnis der Weiterbildung der Offenbarung vermitteln. Sie veranschaulichen Weiterbildungen und dienen im Zusammenhang mit der Beschreibung der Erklärung von Prinzipien und Konzepten der Offenbarung. Andere Weiterbildungen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche, und gleich wirkende Elemente, Merkmale und Komponenten - sofern nichts anderes ausgeführt ist - jeweils mit denselben Bezugszeichen zu versehen.

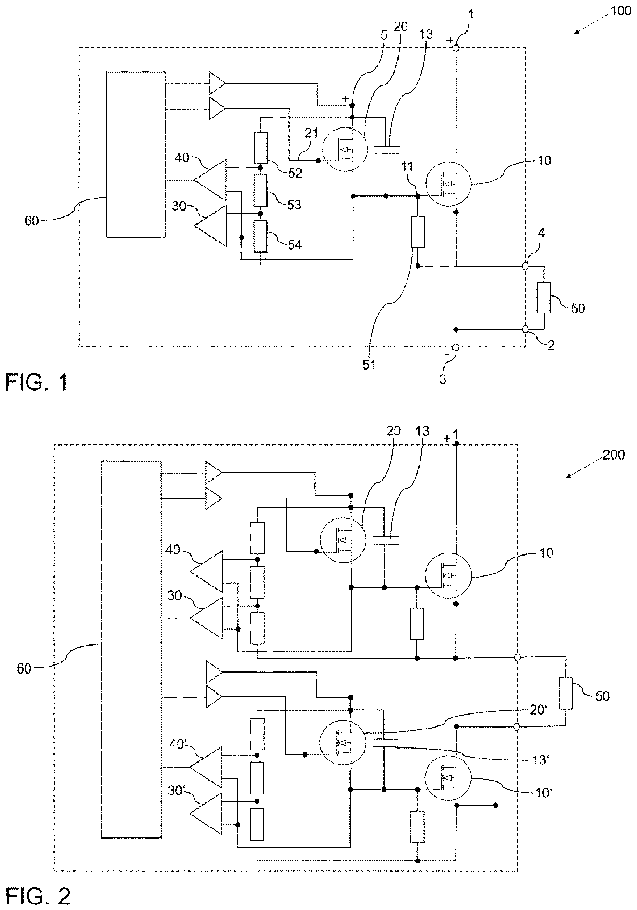

Mit Bezug zu Fig. 1 wird ein erstes Ausführungsbeispiel der Vorrichtung erläutert. Fig. 1 zeigt eine schematische Darstellung einer offenbarungsgemäßen Vorrichtung 100.

Die Vorrichtung 100, insbesondere eine elektronische Vorrichtung, ist vorgesehen zum Überwachen einer Abschaltfähigkeit eines mit einem ersten Strompfad mit einer Stromversorgung 1, 3 verbundenen elektrischen Verbrauchers 50. Der elektrische Verbraucher 50 ist über die Anschlüsse 2, 4 mit der Vorrichtung 100 gekoppelt. Die Anschlüsse 2, 4 stellen einen Ausgang dar, der über ein erstes Stellelement 10 geschaltet werden kann.

Das erste Stellelement 10 ist in dem ersten Strompfad geschaltet und weist eine elektrische Verbindung zu einer Spannungsquelle auf. Das erste Stellelement 10 kann als ein Feldeffekttransistor ausgebildet sein.

Das Stromdurchleitungsvermögen des ersten Stellelements 10 kann mittels eines ersten Stellsignals 11 veränderbar sein. Das erste Stellsignal 11 kann ein Strom oder eine Spannung sein.

Der Betriebszustand des ersten Stellelements 10 kann durch eine erste elektrische Größe, die ein erstes Kapazitätsvermögen C_{GS10} am ersten Stellelement ist, und eine erste Spannung U_{GS10} bedingt, die von einer Spannungsmessvorrichtung 30 ermittelt wird, charakterisiert sein.

Die Spannungsmessvorrichtung 30 kann die erste Spannung an der Gate-Source-Strecke U_{GS10} des ersten Stellelements 10 ermitteln/messen. Die Spannungsmessvorrichtung 30 kann als ein Operationsverstärker ausgebildet sein, der an einem Eingang die Spannung empfängt.

Weitere Ausgestaltungen der Spannungsmessvorrichtung 30 können vorgesehen sein, die einen Wert für die erste Spannung an der Gate-Source-Strecke U_{GS10} des ersten Stellelements 10 ermitteln und/oder bereitstellen. Das erste Stellelement 10 ist mit dem Drain-Anschluss mit der Spannungsversorgung 1 gekoppelt. Ferner ist das erste Stellelement 10 mit dem Source-Anschluss mit dem Verbraucher 50 gekoppelt.

Die Vorrichtung 100 weist in einem zweiten Strompfad ein zweites Stellelement 20 auf. Das zweite Stellelement 20 kann als ein Feldeffekttransistor ausgebildet sein.

Der zweite Strompfad weist eine weitere Stromversorgung 5 auf. Das zweite Stellelement 20 ist ausgebildet, das erste Stellsignal 11 zum Ansteuern des ersten Stellelements 10 bereitzustellen. Insbesondere wird in einem geschalteten Zustand des zweiten Stellelements 20 das erste Stellsignal 11 bereitgestellt.

Das Stromdurchleitungsvermögen des zweiten Stellelements 20 kann durch ein zweites Stellsignal 21 veränderbar sein. Das zweite Stellsignal 21 kann durch eine Steuervorrichtung 60 bereitgestellt werden. Der Betriebszustand des zweiten Stellelements 20 kann durch eine zweite elektrische Größe, die ein zweites Kapazitätsvermögen C_{DS20} am zweiten Stellelement 20 ist und eine zweite Spannung (Drain-Source-Spannung) U_{DS20} bedingt, charakterisiert sein.

Es ist vorgesehen, dass das erste Kapazitätsvermögen und das zweite Kapazitätsvermögen in Reihe geschaltet sind.

Es wird insbesondere ein kapazitiver Spannungsteiler aus dem ersten und dem zweiten Kapazitätsvermögen eingerichtet. Somit bilden bei dem Beispiel die Drain-Source-Kapazität des zweiten Stellelements 20 und die Gate-Source-Kapazität einen kapazitiven Spannungsteiler aus.

Weiterhin ist in der Vorrichtung 100 eine Steuervorrichtung 60 vorgesehen. Die Steuervorrichtung 60 kann als ein Mikrocontroller, FPGA, Computer, SPS oder dergleichen ausgebildet sein. Insbesondere kann die Steuervorrichtung 60 als ein Gerät ausgebildet sein, dass eine Schnittstelle 62 aufweist, die zum Empfangen von Signalen/Daten und zum Bereitstellen von Signalen/Daten eingerichtet ist.

Die Steuervorrichtung 60 ist insbesondere dazu eingerichtet, das zweite Stellelement 20 mittels des zweiten Stellsignals 21 zumindest in zeitlich voneinander beabstandeten Messintervallen anzusteuern.

Durch ein Bereitstellen von Messimpulsen als das zweite Stellsignal 21 kann das zweite Stellelement 20 geschaltet werden beziehungsweise wird bei fehlendem Stellsignal 21 hochohmig geschaltet. Bei einem hochohmig geschalteten zweiten Stellelement 20 teilt sich die Ladungsmenge der Sperrschichtkapazität des ersten Stellelements 10 auf den kapazitiven Teiler auf.

Die geteilte Spannung kann durch die erste Spannungsmessvorrichtung 30 abgefragt und ausgewertet werden, ob sie noch in dem Bereich liegt, der für ein Bestätigen des fehlerfreien Abschaltens vorgegeben ist. In dem Fall, dass das erste Stellelement 10 durchlegiert ist, kann die Spannung außerhalb eines gültigen Bereichs liegen. Womit diagnostiziert werden kann, dass das erste Stellelement 10 nicht mehr abschaltfähig ist. Somit können die gewonnenen Werte der ersten elektrischen Größe auf ein Erkennen einer Fehlfunktion für das Abschalten des ersten Stellelementes 10 ausgewertet werden.

Das Auswerten der gewonnen Werte der ersten elektrischen Größe beinhalten einen Vergleich mit wenigstens einem Referenzvorgabewert.

Der/die Referenzvorgabewert(e) können über einen Widerstandsspannungsteiler 52, 53, 54 bereitgestellt werden. Der Widerstandsspannungsteiler 52, 53, 54 ist mit einer Spannung 5 beaufschlagt. Die Widerstandswerte können so gewählt werden, dass Referenzvorgabewerte bereitgestellt werden, die die Grenzen für die Abschaltfähigkeit des ersten Stellelements 10 gewährleisten können.

Eine erste und einer zweite Spannungsmessvorrichtung 30, 40 können einen Referenzvorgabewert des Widerstandsspannungsteiler 52, 53, 54 empfangen.

Ferner ist die erste Spannungsmessvorrichtung 30 mit dem Gate-Anschluss des ersten Stellelements 10 gekoppelt, um die erste elektrische Größe zu empfangen.

Es kann eine Messung durch einen Vergleich der ersten elektrische Größe umfassend die Gate-Source-Spannung des ersten Stellelements 10 und der Drain-Source-Spannung des zweiten Stellelements 20 mit einem Referenzvorgabewert erfolgen.

Es werden zwei kapazitive Strecken durch die Messung des Spannungsabfalls miteinander verglichen. Wenn die Kapazität der Gate-Source-Strecke kleiner ist als die Kapazität der Drain-Source-Strecke, dann ist die Gate-Source-Spannung größer als die Drain-Source-Spannung und das erste Stellelement 10 dürfte durchgesteuert bleiben.

Durch die offenbarungsgemäße Vorrichtung können zwei Fälle der Durchlegierung, die eine Fehlerfunktion der Abschaltfähigkeit bedingen, abgesichert werden.
- Eine Durchlegierung des ersten Stellelements 10 kann zu einer Verringerung der Sperrschichtkapazität führen, was über den Kapazitätsspannungsteiler zu einer Erhöhung der Spannung führt. Für den Wert der Erhöhung kann ein maximaler Referenzvorgabewert vorgesehen sein.
- Eine Durchlegierung des ersten Stellelements 10 kann zu einem Gate-Schluss führen und zu einer Verringerung der Spannung. Für den Wert der Verringerung kann ein maximaler Referenzvorgabewert vorgesehen sein.

Alternativ zu dem Operationsverstärker kann ein Analog-Digital-Wandler vorgesehen sein.

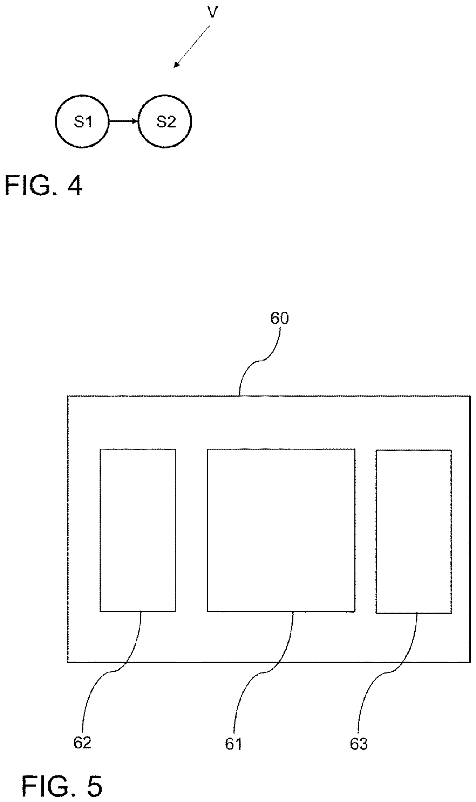

Der Analog-Digital-Wandler kann die erfasste erste elektrische Größe in ein digitales Signal wandeln und der Steuervorrichtung 60, dargestellt in der Fig. 5, über die Schnittstelle 62 bereitstellen.

Die Steuervorrichtung 60 weist insbesondere eine Prozessoreinheit 61 auf.

Die Prozessoreinheit 61 ist ausgebildet, Steuersignale bereitzustellen, um ein zweites Stellelement 20 zumindest in zeitlich voneinander beabstandeten Messintervallen anzusteuern. Die Schnittstelle 62 ist ausgebildet, Steuersignale bereitzustellen und die gewonnenen Werte einer ersten elektrischen Größe des ersten Stellelements 10 zu empfangen.

Zudem ist die Prozessoreinheit 61 weiter ausgebildet, Steuersignale bereitzustellen, um ein Erkennen einer Fehlfunktion für das Abschalten des ersten Stellelementes 10 auszuwerten, und wobei das Auswerten einen Vergleich der gewonnen Werte der ersten elektrischen Größe mit wenigstens einem Referenzvorgabewert beinhaltet.

Die Steuervorrichtung 60 kann eine Speichereinheit 63 aufweisen, in der die entsprechende Referenzvorgabewerte gespeichert sind.

Die Prozessoreinheit 61 der Steuervorrichtung 60 kann die digitalen Signale des Analog-Digital-Wandlers mit den gespeicherten Referenzvorgabewerten vergleichen und das Erkennen einer Fehlfunktion für das Abschalten des ersten Stellelements 10 signalisieren. Die Steuervorrichtung 60 kann dahingehend ein Signal bereitstellen, dass an weitere Geräte zum Ausgeben einer Warnung übergeben wird.

Ferner kann die Steuervorrichtung 60 weitere Geräte zum Triggern einer Warnung ansteuern.

In einer Ausführungsform, mit Bezug zu Fig. 1 kann vorgesehen, dass eine weitere Kapazität 13 in Reihe mit der zu messenden Kapazität des ersten Stellelements 10 (Sperrschichtkapazität) geschaltet wird. Hierdurch kann die Drain-Source-Kapazität und somit das zweite Stellelement 20 kleiner ausgelegt werden.

Die weitere Kapazität 13 kann durch das zweite Stellelement 20 geschaltet werden. Die Kapazität 13 ist so gewählt, dass in einem kapazitiven Spannungsteiler noch entsprechend Spannung am ersten Stellelement 10 anliegt, so dass dieser schaltet.

Die Sperrschichtkapazität (Gate-Source) des ersten Stellelements 10 und die weitere Kapazität 13 können so dimensioniert sein, dass sie in derselben Größenordnung liegen, zum Beispiel im Bereich zwischen 100 pF bis 10 nF.

Wenn das zweite Stellelement 20 hochohmig geschaltet wird, teilt sich die Ladungsmenge der Sperrschichtkapazität des ersten Stellelements 10 auf den kapazitiven Teiler bestehen aus der weiteren Kapazität 13 (alternativ der Kapazität der Drain-Source-Strecke des zweiten Stellelements 20) auf. Die geteilte Spannung sollte so dimensioniert sein, dass die Sperrschichtkapazität ausreichend geladen ist, um das erste Stellelement 10 weiter durchzusteuern.

Die geteilte Spannung kann auf einen Bereich abgefragt werden, innerhalb der sie liegen muss.

Wenn das erste Stellelement 10 durchlegiert ist, dann liegt die Spannung außerhalb des gültigen Bereiches. Damit kann ausgewertet werden, dass das este Stellelement 10 nicht mehr abschaltfähig ist.

Die Vorrichtung 10 ist so gestaltet, dass der Ausgang abgeschaltet wird, wenn an dem Drain-Anschluss von dem zweiten Stellelement 20 keine Spannung anliegt. Es wird für die Dauer eines kurzen Testpulses die Durchschaltenergie bereitgestellt. Dazu kann ein Widerstand 51 vorgesehen sein, der so dimensioniert wird, dass ein beliebiger Fehler von dem zweiten Stellelement 20 nicht dazu führen kann, dass das erste Stellelement 10 nicht innerhalb einer vorgegebenen Prozesssicherheitszeit abschaltet.

In einer alternativen Ausgestaltung kann vorgesehen sein, dass die aus der kapazitiven Entladung resultierende Änderung der Drain-Source Spannung gemessen wird. Das kann einerseits über eine Verschaltung erfolgen, die nur den Wechselspannungsanteil misst, oder andererseits durch einen Bandpass-Filter, wenn in einer bestimmten Frequenz zyklisch ab- und zugeschaltet wird Die Spannungen könnten auch mit einem Analog-Digital-Wandler erfasst und gemessen werden. Diesbezüglich kann die Sperrschichtkapazität mit einem anderen/weiteren Messprinzip ermittelt werden.

Es kann vorgesehen sein, anstatt mittels eines kapazitiven Spannungsteilers die Kapazität an der Entladekurve zu ermitteln. Ergibt sich, dass die in Fig. 1 dargestellte Kapazität C_{DS20} sehr klein ist gegenüber der zu messenden Sperrschichtkapazität, also in erster Näherung vernachlässigt werden kann, und die Kapazität 13 nicht vorgesehen ist, dafür aber der Widerstand 51 geeignet dimensioniert ist, dann kann die Sperrschichtkapazität über die Entladezeit ermittelt werden. Dabei kann ein Testimpuls gestartet werden und die Zeit gemessen werden, die vergeht, bis die Spannung unter einen Referenzwert sinkt.

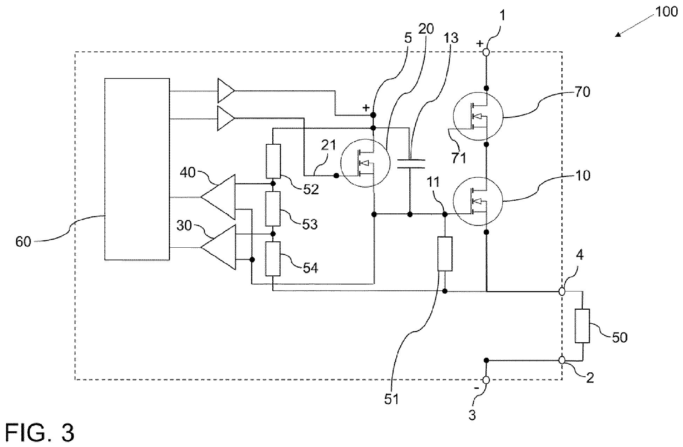

In einer alternativen/ergänzenden Ausgestaltung weist die Vorrichtung 100 gemäß der Fig. 3 ein drittes Stellelement 70 auf.

Das dritte Stellelement 70 ist in den ersten Strompfad in Reihe zu dem ersten Stellelement 10 geschaltet. Sollte ausgewertet werden, dass die Spannung unterhalb eines vorgegebenen Referenzvorgabewert vermindert ist, ist das erste Stellelement 10 nicht weiter abschaltfähig.

Der Ausgang 4, 2 und/oder der elektrische Verbraucher 50 wird/werden über einen zweiten Abschaltweg umfassend das dritte Stellelement 70 abgeschaltet. Eine Fehlermeldung wird ausgegeben und eine erneute Zuschaltung unterbunden. Das dritte Stellelement 70 kann über die Steuervorrichtung 60 angesteuert werden.

Mit Bezug zu Fig. 2 wird eine weitere Ausgestaltung der Vorrichtung erläutert. Dabei wird von dem oben mit Bezug zu Fig. 1 erläuterten ersten Ausführungsbeispiel der Vorrichtung ausgegangen; gleiche oder gleichwirkende Elemente sind mit den gleichen Referenzzeichen versehen und werden nicht erneut im Detail beschrieben. Insbesondere kann der Fig. 2 das offenbarungsgemäße System 200 entnommen werden.

Das System 200 weist eine erste und eine zweite offenbarungsgemäße Vorrichtung 100 auf. Die erste und die zweite Vorrichtung 100 sind liegen dupliziert vor und sind derart angeordnet, dass der Minuspol der ersten (oberen) Vorrichtung (100) mit dem Pluspol der (unteren) Vorrichtung 100 gekoppelt ist. Ferner weist das System 200 einen Ausgang 201 zum Abgreifen der Spannung am Minuspol auf. Die erste Vorrichtung 100 und die zweite Vorrichtung koppeln einen Verbraucher 50.

In der Ausgestaltung des Systems 200 ist ein zweiter Abschaltkanal vorgesehen. Durch die zwei Vorrichtungen 100 zum Schalten des Plus- und Minus-Kanals verbleibt auch bei einem Querschluss außerhalb des Geräts ein zweiter Abschaltkanal. Sollte der Fall eintreten, dass der Verbraucher 50 am Plus-Kanal durch einen Fehler fremdversorgt wird, kann die zweite Vorrichtung 100 (als M-Schalter) den Stromfluss noch unterbinden. Sollte der Fall eintreten, bei dem am Minus-Kanal des Verbrauchers 50 ein Erdschluss vorliegt, so kann die erste Vorrichtung 100 (als P-Schalter) den Stromfluss noch unterbinden.

Fig. 4 zeigt ein Ablaufdiagram eines offenbarungsgemäßen Verfahrens. In Fig. 4 bezeichnet das Bezugszeichen V eine Ausführungsform des offenbarungsgemäßen Verfahrens. Das Verfahren V zum Überwachen einer Abschaltfähigkeit weist mehrere Verfahrensschritte auf. Das Verfahren V kann durch die Prozessoreinheit 61 der Steuervorrichtung 60 ausgeführt werden. In einem ersten Schritt S1 wird das zweite Stellelement 20 mittels des zweiten Stellsignals 21 zumindest in zeitlich voneinander beabstandeten Messintervallen angesteuert. In einem zweiten Schritt S2 werden dabei gewonnene Werte der ersten elektrischen Größe auf ein Erkennen einer Fehlfunktion für das Abschalten des ersten Stellelementes 10 auswertet.

### Bezugszeichenliste

- 1,3: Stromversorgung
- 10: erstes Stellelement
- 11: erstes Stellsignal
- 13: Kapazität
- 20: zweites Stellelement
- 21: zweites Stellsignal
- 30: Spannungsmesseinrichtung
- 40: Spannungsmesseinrichtung
- 50: Verbraucher
- 51: Widerstandselement
- 52,53,54: Widerstandsspannungsteiler
- 60: Steuervorrichtung
- 61: Prozessoreinheit
- 62: Schnittstelle
- 63: Speichereinheit
- 70: drittes Stellelement
- 71: drittes Stellsignal
- 100: Vorrichtung
- 200: System
- 201: Minuspol der Spannungsversorgung

- V: Verfahren
- S1-S2: Verfahrensschritte

## Patentansprüche

1. Vorrichtung (100) zum Überwachen einer Abschaltfähigkeit eines mit einem ersten Strompfad mit einer Stromversorgung (1, 3) verbundenen elektrischen Verbrauchers (50), wobei
im ersten Strompfad ein erstes elektrisches Stellelement (10) vorgesehen ist, dessen Stromdurchleitungsvermögen mittels eines ersten Stellsignals (11) veränderbar ist, wobei
der Betriebszustand des ersten Stellelements (10) durch eine erste elektrische Größe, die ein erstes Kapazitätsvermögen (C_{GS10}) am ersten Stellelement (10) ist, und eine erste Spannung (U_{GS10}) bedingtcharakterisiert ist, wobei die Vorrichtung (100) in einem zweiten Strompfad mit einer weiteren Stromversorgung (5) ein zweites Stellelement (20) zum Bereitstellen des erstens Stellsignals (11) vorsieht, dessen Stromdurchleitungsvermögen mittels eines zweiten Stellsignals (21) veränderbar ist, wobei
der Betriebszustand des zweiten Stellelements (20) durch eine zweite elektrische Größe, die ein zweites Kapazitätsvermögen (C_{DS20}) am zweiten Stellelement (20) ist, und eine zweite Spannung (U_{DS20}) bedingt, charakterisiert ist, wobei
das erste Kapazitätsvermögen eine Gate-Source Kapazität des ersten elektrischen Stellelements (10) ist und das zweite Kapazitätsvermögen eine Drain-Source Kapazität des zweiten elektrischen Stellelements (20) ist, wobei die Kapazitätsvermögen in Reihe geschaltet sind, und wobei weiterhin eine Steuervorrichtung (60) vorgesehen ist, die ausgebildet ist, das zweite Stellelement (20) mittels des zweiten Stellsignals (21) zumindest in zeitlich voneinander beabstandeten Messintervallen anzusteuern und dabei gewonnene Werte der ersten elektrischen Größe auf ein Erkennen einer Fehlfunktion für das Abschalten des ersten Stellelementes (10) auszuwerten, und wobei
das Auswerten einen Vergleich der gewonnen Werte der ersten elektrischen Größe mit wenigstens einem Referenzvorgabewert beinhaltet, wobei als Kapazitätsvermögen eine elektrische Größe verstanden wird, mit der Fähigkeit eine elektrische Ladung zu speichern und eine Kapazität aufzubauen,
wobei die Steuervorrichtung (60) vorgesehen ist, den Wert für die erste elektrische Größe mit wenigstens einem ersten und/oder zweiten Referenzvorgabewert zu vergleichen, und
wobei der/die Referenzvorgabewert(e) über einen Widerstandsspannungsteiler (52, 53, 54) bereitgestellt werden.

2. Vorrichtung (100) gemäß Anspruch 1, wobei eine Kapazität (13) vorgesehen ist und die Kapazität (13) zum Vergrößern des Kapazitätsvermögen des zweiten Stellelements (20) parallel zum zweiten Stellelement (20) gekoppelt ist; wobei, optional, das zweite Kapazitätsvermögen oder das zweite Kapazitätsvermögen in Parallelschaltung mit der Kapazität (13) und das erste Kapazitätsverhalten eine gleiche Kapazitätsgrößenordnung aufweisen, wobei insbesondere die Kapazitätsgrößenordnung in einem Bereich von wenigstens 100 pF bis höchstens 10 nF liegt.

3. Vorrichtung (100) gemäß einem der vorhergehenden Ansprüche,
wobei das erste Stellelement (10) und das zweite Stellelement (20) ein Transistor ist und das Stellsignal ein Steuerstrom oder eine Steuerspannung (U_{GS10}, U_{GS20}) ist,
wobei vorgesehen ist, dass der Transistor ein n-Kanal- oder ein p-Kanal-Feldeffekttransistor ist.

4. Vorrichtung (100) gemäß einem der vorhergehenden Ansprüche, wobei die Spannungsmesseinrichtung (30) als ein Operationsverstärker ausgebildet ist oder als ein Analog-Digital-Wandler ausgebildet ist und in Abhängigkeit von dem Wert für die erste elektrische Größe ein digitales Signal an die Steuervorrichtung (60) bereitstellt.

5. Vorrichtung (100) gemäß einem der vorhergehenden Ansprüche, wobei zum Erkennen das keine Fehlfunktion für das Abschalten des ersten Schaltelements (10) vorliegt, die erste elektrische Größe ausgehend von einem Maximalwert um einen Faktor vermindert ist, so dass das erste Stellelement (10) noch nicht abgeschaltet wird oder abgeschaltet verbleibt und dass durch den Verbraucher (50) ein zum Ausführen von dessen Funktion ausreichender Strom fließt.

6. Vorrichtung (100) gemäß einem der vorhergehenden Ansprüche, wobei in dem ersten Strompfad ein drittes Stellelement (70) vorgesehen ist, und das dritte Stellelement (70) in Reihe zu dem ersten Stellelement (10) geschaltet ist; wobei,
optional, zum Erkennen einer Fehlfunktion für das Abschalten des ersten Stellelements (10) die erste elektrische Größe ausgehend von einem Maximalwert um einen Faktor soweit vermindert ist, dass das erste Stellelement (10) nicht mehr abgeschaltet wird und der zum Ausführen der Funktion des Verbrauchers (50) ausreichende Strom mittels des dritten Stellelements (70) unterbunden wird.

7. Vorrichtung (100) gemäß einem der vorhergehenden Ansprüche,
wobei die Vorrichtung (100) ferner ein Widerstandselement (51) aufweist, und wobei das Widerstandselement (51) parallel zum ersten Kapazitätsvermögen (C_{GS10}) des ersten Stellelements (10) geschaltet ist.

8. Verfahren (V) zum Überwachen einer Abschaltfähigkeit eines mit einem ersten Strompfad mit einer Stromversorgung (1, 3) verbundenen elektrischen Verbrauchers (50), wobei
im ersten Strompfad ein erstes elektrisches Stellelement (10) vorgesehen ist, dessen Stromdurchleitungsvermögen mittels eines ersten Stellsignals (11) veränderbar ist, wobei
der Betriebszustand des ersten Stellelements (10) durch eine erste elektrische Größe, die die Gate-Source-Kapazität (CGS10) des ersten Stellelements (10) ist , und eine erste Spannung (UGS10) bedingt, die von einer Spannungsmesseinrichtung (30, 40) ermittelt wird, charakterisiert ist, wobei die Vorrichtung (100) in einem zweiten Strompfad mit einer weiteren Stromversorgung (5) ein zweites Stellelement (20) zum Bereitstellen des erstens Stellsignals (11) vorsieht, dessen Stromdurchleitungsvermögen mittels eines zweiten Stellsignals (21) veränderbar ist, wobei
der Betriebszustand des zweiten Stellelements (20) durch eine zweite elektrische Größe, die die Drain-Source-Kapazität des zweiten Stellelements (20) ist, und eine zweite Spannung (UGS20) bedingt, charakterisiert ist, wobei die Gate-Source-Kapazität (CGS10) des ersten Stellelements (10) und die Drain-Source-Kapazität des zweiten Stellelements (20) in Reihe geschaltet sind, und wobei
eine Steuervorrichtung (60) das zweite Stellelement (20) mittels des zweiten Stellsignals (21) zumindest in zeitlich voneinander beabstandeten Messintervallen ansteuert (S1) und dabei gewonnene Werte der ersten elektrischen Größe auf ein Erkennen einer Fehlfunktion für das Abschalten des ersten Stellelementes (10) auswertet (S2), und wobei
das Auswerten einen Vergleich der gewonnen Werte mit wenigstens einem Referenzvorgabewert beinhaltet, wobei der Referenzvorgabewert über einen Widerstandsspannungsteiler (52, 53, 54) bereitgestellt wird, wobei als Kapazitätsvermögen eine elektrische Größe verstanden wird, mit der Fähigkeit eine elektrische Ladung zu speichern und eine Kapazität aufzubauen.

9. Steuervorrichtung (60) zum Überwachen einer Abschaltfähigkeit eines mit in einer Vorrichtung (100) gemäß einem der vorhergehenden Vorrichtungsansprüche einem ersten Strompfad mit einer Stromversorgung (1, 3) über ein erstes Stellelement (10) verbundenen elektrischen Verbrauchers (50), die Steuervorrichtung (60) ferner ausgebildet ist, das Verfahren gemäß des Verfahrensanspruchs auszuführen, mit:
- einer Prozessoreinheit (61), die ausgebildet ist, Steuersignale bereitzustellen, um ein zweites Stellelement (20) zumindest in zeitlich voneinander beabstandeten Messintervallen anzusteuern; und
- einer Schnittstelle (62), die ausgebildet ist, Steuersignale bereitzustellen und gewonnene Werte einer ersten elektrischen Größe der Gate-Source-Kapazität (CGS10) des ersten Stellelements (10) zu empfangen;
- wobei die Prozessoreinheit (61) weiter ausgebildet ist, Steuersignale bereitzustellen, um ein Erkennen einer Fehlfunktion für das Abschalten des ersten Stellelementes (10) auszuwerten, und
- wobei das Auswerten einen Vergleich der gewonnen Werte der ersten elektrischen Größe mit wenigstens einem Referenzvorgabewert beinhaltet,
wobei der Referenzvorgabewert über einen Widerstandsspannungsteiler (52, 53, 54) bereitgestellt wird.

## Claims

1. Device (100) for monitoring a switch-off capability of an electrical load (50) connected to a first current path having a current supply (1, 3), wherein
a first electrical actuating element (10) is provided in the first current path, the current-conducting capacity of which first electrical actuating element is able to be altered by means of a first actuating signal (11), wherein
the operating state of the first actuating element (10) is **characterized by** a first electrical variable, which is a first capacitance capacity (C_{GS10}) at the first actuating element (10) and induces a first voltage (U_{GS10}), wherein
the device (100) provides, in a second current path having a further current supply (5), a second actuating element (20) for providing the first actuating signal (11), the current-conducting capacity of which second actuating element is able to be altered by means of a second actuating signal (21), wherein
the operating state of the second actuating element (20) is **characterized by** a second electrical variable, which is a second capacitance capacity (C_{DS20}) at the second actuating element (20) and induces a second voltage (Uds20), wherein the first capacitance capacity is a gate-source capacitance of the first electrical actuating element (10) and the second capacitance capacity is a drain-source capacitance of the second electrical actuating element (20), wherein the capacitance capacities are connected in series, and wherein
furthermore, a control device (60) is provided, which is designed to drive the second actuating element (20) by means of the second actuating signal (21) at least at measurement intervals that are temporally spaced apart from one another, and to evaluate values of the first electrical variable that were obtained in the process, in order to detect a malfunction for switching off the first actuating element (10), and wherein
the evaluation includes comparing the obtained values of the first electrical variable with at least one predefined reference value, wherein capacitance capacity is understood to mean an electrical variable having the capability to store an electrical charge and build up a capacitance,
wherein the control device (60) is provided to compare the value for the first electrical variable with at least one first and/or second predefined reference value, and
wherein the one or more predefined reference values are provided via a resistor voltage divider (52, 53, 54).

2. Device (100) according to Claim 1, wherein a capacitor (13) is provided and the capacitor (13) is coupled in parallel with the second actuating element (20) in order to increase the capacitance capacity of the second actuating element (20); wherein, optionally, the second capacitance capacity or the second capacitance capacity connected in parallel with the capacitor (13) and the first capacitance behaviour have the same capacitance magnitude, wherein in particular the capacitance magnitude is in a range from at least 100 pF to at most 10 nF.

3. Device (100) according to either of the preceding claims,
wherein the first actuating element (10) and the second actuating element (20) is a transistor and the actuating signal is a control current or a control voltage (U_{GS10}, U_{GS20}),
wherein provision is made for the transistor to be an n-channel or p-channel field-effect transistor.

4. Device (100) according to one of the preceding claims, wherein the voltage measuring device (30) is designed as an operational amplifier or is designed as an analogue-to-digital converter and provides a digital signal to the control device (60) in dependence on the value for the first electrical variable.

5. Device (100) according to one of the preceding claims, wherein, in order to detect that there is no malfunction for the switching-off of the first switching element (10), the first electrical variable is reduced by a factor starting from a maximum value, such that the first actuating element (10) is not yet switched off or remains switched off and that there flows through the load (50) a current sufficient to perform the function thereof.

6. Device (100) according to one of the preceding claims, wherein a third actuating element (70) is provided in the first current path, and the third actuating element (70) is connected in series with the first actuating element (10); wherein, optionally, in order to detect a malfunction for the switching-off of the first actuating element (10), the first electrical variable is reduced by a factor starting from a maximum value to such an extent that the first actuating element (10) is no longer switched off and the current sufficient to perform the function of the load (50) is prevented by means of the third actuating element (70).

7. Device (100) according to one of the preceding claims,
wherein the device (100) further has a resistor element (51), and
wherein the resistor element (51) is connected in parallel with the first capacitance capacity (C_{GS10}) of the first actuating element (10).

8. Method (V) for monitoring a switching-off capability of an electrical load (50) connected to a first current path having a current supply (1, 3), wherein
a first electrical actuating element (10) is provided in the first current path, the current-conducting capacity of which first electrical actuating element is able to be altered by means of a first actuating signal (11), wherein
the operating state of the first actuating element (10) is **characterized by** a first electrical variable, which is the gate-source capacitance (CGS10) of the first actuating element (10) and induces a first voltage (UGS10), which is ascertained by a voltage measuring device (30, 40), wherein the device (100) provides, in a second current path having a further current supply (5), a second actuating element (20) for providing the first actuating signal (11), the current-conducting capacity of which second actuating element is able to be altered by means of a second actuating signal (21), wherein
the operating state of the second actuating element (20) is **characterized by** a second electrical variable, which is the drain-source capacitance of the second actuating element (20) and induces a second voltage (UGS20), wherein the gate-source capacitance (CGS10) of the first actuating element (10) and the drain-source capacitance of the second actuating element (20) are connected in series, and wherein
a control device (60) drives (S1) the second actuating element (20) by means of the second actuating signal (21) at least at measurement intervals that are temporally spaced apart from one another, and evaluates (S2) values of the first electrical variable that were obtained in the process, in order to detect a malfunction for switching off the first actuating element (10), and wherein the evaluation includes comparing the obtained values with at least one predefined reference value, wherein the predefined reference value is provided via a resistor voltage divider (52, 53, 54), wherein capacitance capacity is understood to mean an electrical variable having the capability to store an electrical charge and build up a capacitance.

9. Control device (60) for monitoring a switch-off capability of an electrical load (50) connected, in a device (100) according to one of the preceding device claims, to a first current path having a current supply (1, 3) via a first actuating element (10), the control device (60) furthermore being designed to perform the method according to the method claim, having:
- a processor unit (61), which is designed to provide control signals in order to drive a second actuating element (20) at least at measurement intervals that are temporally spaced apart from one another; and
- an interface (62), which is designed to provide control signals and to receive obtained values of a first electrical variable of the gate-source capacitance (CGS10) of the first actuating element (10);
- wherein the processor unit (61) is furthermore designed to provide control signals in order to evaluate detection of a malfunction for the switching-off of the first actuating element (10), and
- wherein the evaluation includes comparing the obtained values of the first electrical variable with at least one predefined reference value,
wherein the predefined reference value is provided via a resistor voltage divider (52, 53, 54).

## Revendications

1. Dispositif (100) de surveillance d'une capacité d'arrêt d'un consommateur (50) électrique relié à une alimentation en courant (1, 3) par un premier trajet de courant,
un premier élément de réglage (10) électrique, dont la capacité de transmission de courant peut être modifiée au moyen d'un premier signal de réglage (11), étant prévu sur le premier trajet de courant,
l'état de fonctionnement du premier élément de réglage (10) étant **caractérisé par** une première grandeur électrique, qui est une première capacité (C_{GS10}) sur le premier élément de réglage (10), et par une première tension (U_{GS10}),
le dispositif (100) prévoyant dans un deuxième trajet de courant avec une alimentation en courant supplémentaire (5) un deuxième élément de réglage (20) pour fournir le premier signal de réglage (11), dont la capacité de transmission de courant peut être modifiée au moyen d'un deuxième signal de réglage (21), l'état de fonctionnement du deuxième élément de réglage (20) étant **caractérisé par** une deuxième grandeur électrique, qui est une deuxième capacité (C_{DS20}) sur le deuxième élément de réglage (20), et par une deuxième tension (Uds20),
la première capacité étant une capacité grille-source du premier élément de réglage (10) électrique et la deuxième capacité étant une capacité drain-source du deuxième élément de réglage (20) électrique, la capacité étant branchée en série, et
un dispositif de commande (60) étant par ailleurs prévu, qui est formé pour piloter le deuxième élément de réglage (20) au moyen du deuxième signal de réglage (21) au moins à des intervalles de mesure espacés les uns des autres dans le temps et pour évaluer des valeurs ainsi obtenues de la première grandeur électrique quant à une identification d'un dysfonctionnement pour arrêter le premier élément de réglage (10), et
l'évaluation contenant une comparaison des valeurs obtenues de la première grandeur électrique à au moins une valeur spécifiée de référence, une grandeur électrique étant comprise comme une capacité, avec une capacité à stocker une charge électrique et à établir une capacité,
le dispositif de commande (60) étant prévu pour comparer la valeur de la première grandeur électrique à au moins une première et/ou deuxième valeur spécifiée de référence, et
la/les valeurs spécifiées de référence étant fournies par un diviseur de tension de résistance (52, 53, 54).

2. Dispositif (100) selon la revendication 1, une capacité (13) étant prévue et la capacité (13) étant couplée parallèlement au deuxième élément de réglage (20) pour augmenter la capacité du deuxième élément de réglage (20) ; en option la deuxième capacité ou la deuxième capacité dans le branchement parallèle avec la capacité (13) et le premier comportement de capacité présentant un ordre de grandeur de capacité égal, en particulier l'amplitude de capacité se trouvant en particulier dans une plage d'au moins 100 pF à 10 nF au maximum.

3. Dispositif (100) selon l'une des revendications précédentes,
le premier élément de réglage (10) et le deuxième élément de réglage (20) étant un transistor et le signal de réglage étant un courant de commande ou une tension de commande (U_{GS10}, U_{GS20}),
le fait que le transistor est un transistor à effet de champ à canal n ou à canal p étant prévu

4. Dispositif (100) selon l'une des revendications précédentes, le système de mesure de tension (30) étant formé comme un amplificateur de fonctionnement ou étant formé comme un convertisseur analogique/numérique et un signal numérique étant fourni au dispositif de commande (60) en fonction de la valeur de la première grandeur électrique.

5. Dispositif (100) selon l'une des revendications précédentes, la première grandeur électrique étant réduite d'un facteur en partant d'une valeur maximale pour identifier l'absence de dysfonctionnement pour arrêter le premier élément de commutation (10) de telle sorte que le premier élément de réglage (10) n'est pas encore arrêté ou reste arrêté et qu'un courant suffisant pour exécuter la fonction du consommateur (50) traverse celui-ci.

6. Dispositif (100) selon l'une des revendications précédentes, un troisième élément de réglage (70) étant prévu dans le premier chemin de courant, et le troisième élément de réglage (70) étant branché en série avec le premier élément de réglage (10) ;
en option, la première grandeur électrique étant réduite d'un facteur en partant d'une valeur maximale pour identifier un dysfonctionnement pour l'arrêt du premier élément de réglage (10) dans la mesure où le premier élément de réglage (10) n'est plus arrêté et le courant suffisant pour exécuter la fonction du consommateur (50) est coupé au moyen du troisième élément de réglage (70).

7. Dispositif (100) selon l'une des revendications précédentes,
le dispositif (100) comportant en outre un élément de résistance (51), et
l'élément de résistance (51) étant branché en parallèle avec la première capacité (C_{GS10}) du premier élément de réglage (10).

8. Procédé (V) de surveillance d'une capacité d'arrêt d'un consommateur (50) électrique relié à une alimentation en courant (1, 3) par un premier trajet de courant,
un premier élément de réglage (10) électrique, dont la capacité de transmission de courant peut être modifiée au moyen d'un premier signal de réglage (11), étant prévu sur le premier trajet de courant,
l'état de fonctionnement du premier élément de réglage (10) étant **caractérisé par** une première grandeur électrique, qui est la capacité grille-source (CGS10) du premier élément de réglage (10), et par une première tension (UGS10) déterminée par un système de mesure de tension (30, 40), le dispositif (100) prévoyant dans un deuxième trajet de courant avec une autre alimentation en courant (5), un deuxième élément de réglage (20) pour fournir le premier signal de réglage (11), dont la capacité de transmission de courant peut être modifiée au moyen d'un deuxième signal de réglage (21),
l'état de fonctionnement du deuxième élément de réglage (20) étant **caractérisé par** une deuxième grandeur électrique, qui est la capacité drain-source du deuxième élément de réglage (20), et par une deuxième tension (UGS20), la capacité grille-source (CGS10) du premier élément de réglage (10) et la capacité drain-source du deuxième élément de réglage (20) étant branchées en série, et un dispositif de commande (60) pilotant (S1) le deuxième élément de réglage (20) au moyen du deuxième signal de réglage (21) au moins à des intervalles de mesure espacés les uns des autres dans le temps et évaluant (S2) ainsi des valeurs obtenues de la première grandeur électrique quant à une identification d'un dysfonctionnement pour l'arrêt du premier élément de réglage (10), et
l'évaluation comprenant une comparaison des valeurs obtenues à au moins une valeur spécifiée de référence, la valeur spécifiée de référence étant fournie par un diviseur de tension de résistance (52, 53, 54), une grandeur électrique étant considérée comme une capacité, avec la capacité de stocker une charge électrique et d'établir une capacité.

9. Dispositif de commande (60) destiné à surveiller une capacité d'arrêt d'un consommateur (50) électrique relié à une alimentation en courant (1, 3) par un premier élément de réglage (10) par un premier chemin de courant dans un dispositif (100) selon l'une des revendications de dispositif précédentes, le dispositif de commande (60) étant en outre formé pour exécuter le procédé selon la revendication de procédé, avec :
- une unité de traitement (61), qui est formée pour fournir des signaux de commande pour piloter un deuxième élément de réglage (20) à des intervalles de mesure espacés les uns des autres dans le temps ; et
- une interface (62), qui est formée pour fournir des signaux de commande et pour recevoir des valeurs obtenues d'une première grandeur électrique de la capacité grille-source (CGS10) du premier élément de réglage (10),
- l'unité de traitement (61) étant par ailleurs formée pour fournir des signaux de commande pour évaluer une identification d'un dysfonctionnement pour l'arrêt du premier élément de réglage (10), et
- l'évaluation contenant une comparaison des valeurs obtenues de la première grandeur électrique à au moins une valeur spécifiée de référence,
la valeur spécifiée de référence étant fournie par un diviseur de tension de résistance (52, 53, 54).
